# EUROPÄISCHE PATENTSCHRIFT

(11) **EP 1 214 743 B1**
(45) Veröffentlichungstag und Bekanntmachung des Hinweises auf die Patenterteilung: **10.05.2006**
(21) Anmeldenummer: 00974324.6
(22) Anmeldetag: 14.09.2000
(51) Int. Cl.: H01L 29/49, H01L 29/788, H01L 29/423

(54) **VERFAHREN ZUR FERTIGUNG VON SPEICHER- UND LOGIKTRANSISTOREN**
METHOD FOR PRODUCING MEMORY AND LOGIC TRANSISTORS
PROCEDE DE PRODUCTION DE TRANSISTORS DE MEMOIRE ET DE LOGIQUE

(30) Priorität: 22.09.1999 DE 19945433
(43) Veröffentlichungstag der Anmeldung: 19.06.2002
(73) Patentinhaber: Infineon Technologies AG, 81669 München (DE)
(72) Erfinder: SCHWALKE, Udo, 84431 Heldenstein (DE); VON SCHWERIN, Andreas, 81539 München (DE)
(74) Vertreter: Kindermann, Peter
(86) Internationale Anmeldenummer: PCT/DE2000/003205
(87) Internationale Veröffentlichungsnummer: WO 2001/022496

(56) Entgegenhaltungen:
- EP-A- 0 416 707
- EP-A- 0 614 226
- US-A- 4 811 078
- KIM K T ET AL: "TUNGSTEN SILICIDE/TITANIUM NITRIDE COMPOUND GATE FOR SUBMICRON CMOSFET" SYMPOSIUM ON VLSI TECHNOLOGY,US,NEW YORK, IEEE, Bd. SYMP. 10, 4. Juni 1990 (1990-06-04), Seiten 115-116, XP000166322

## Beschreibung

Die Erfindung betrifft ein Verfahren zur Herstellung einer integrierten Halbleiterschaltung, bei dem eine erste Gateschicht auf erste und zweite Flächenbereiche eines Halbleitersubstats aufgebracht wird und auf der ersten Gateschicht in den zweiten Flächenbereichen eine isolierende Schicht erzeugt wird, die dort zur Isolation der ersten Gateschicht von einer weiteren Gateschicht dient, und bei dem auf den ersten und zweiten Flächenbereichen eine zweite Gateschicht aufgebracht wird, die vorzugsweise eine höhere elektrische Leitfähigkeit als die erste Gateschicht besitzt.

Verfahren dieser Art werden zur Fertigung von Halbleiterschaltungen eingesetzt, die sowohl in Speicherbereichen als auch in Logikbereichen Transistoren aufweisen. Die Transistoren in beiden Bereichen werden so weit wie möglich mit denselben Prozeßschritten hergestellt, um Zeit- und Kostenaufwand so gering wie möglich zu halten. Transistoren in Speicherzellen sind häufig Floating-Gate-Transistoren mit einem Control-Gate und einem Floating-Gate, wohingegen Logiktransistoren meist gewöhnliche MOSFETs sind. Die Gateschichten bestehen meist aus Polysilizium und werden der besseren Leitfähigkeit halber von Titansilizid bedeckt. Titansilizid bildet somit eine zweite Gateschicht der Logiktransistoren bzw. eine zweite Gateschicht des Control-Gates der Speichertransistoren. Das Control-Gate selbst befindet sich über einer isolierenden Schicht, die das Floating-Gate bedeckt.

Das Control-Gate besteht meist ebenso wie das Floating-Gate oder das Gate der Logik-Transistoren aus Polysilizium. Das Control-Gate, das nur in den Speicherzellen vorgesehen ist, wird aus Kostengründen in demselben Verfahrensschritt wie die Logiktransistoren mit der Titansilizidschicht bedeckt. Dadurch entsteht jedoch eine Topologie, d. h. ein Höhensprung der Titansilizidschicht, der die weitere Fertigung der integrierten Halbleiterschaltung erschwert. Da jedoch Speichertransistoren und Logiktransistoren duch ihre unterschiedliche Bauweise zwangsläufig unterschiedlich viele Gateschichten aufweisen, ist diese Topologie mit herkömmlichen Mitteln nicht zu vermeiden.

Aus US-A-4811078 ist ein Verfahren zur Marstellung einer integrierten Halbleiterschaltung bekannt, bei dem eine als zweite Gateschicht dienende TiN-Schicht ausgebildet wird.

Aus EP-A-0 614226 ist auch eine Gateelektroden-Struktur bekannt. Es ist daher die Aufgabe der vorliegenden Erfindung, ein Verfahren zur Herstellung einer integrierten Halbleiterschaltung bereitzustellen, bei dem die Gatestrukturen so verändert werden, daß eine Topologiestufe zwischen Speicherbereich und Logikbereich entfällt. Das Verfahren soll zudem nicht aufwendiger, möglichst noch einfacher als das gattungsbildende Verfahren sein.

Diese Aufgabe wird erfindungsgemäß dadurch gelöst, daß die zweite Gateschicht aus einem Material hergestellt wird, daß auf die isolierende Schicht aufbringbar ist, ohne diese zu verändern, und daß die zweite Gateschicht in den zweiten Flächenbereichen als weitere Gateschicht unmittelbar auf die isolierende Schicht aufgebracht wird und in die erste Gateschicht und das Halbleitersubstrat vor dem Aufbringen der zweiten Gateschicht shallow Trenches geätzt werden. Die der Erfindung zugrundeliegende Überlegung besteht darin, daß im Falle von Gateschichtstrukturen, die aus einer unteren Gateschicht (aus Polysilizium) und einer oberen, leitfähigkeitssteigernden zweiten Gateschicht (aus Titansilizid) bestehen, die zweite Schicht grundsätzlich als Control-Gate in den Speichertransistoren verwandt werden kann. In diesem Fall könnte die bisher eingesetzte zweite Polysiliziumschicht, die nur im Bereich der Speicherzellen aufgebracht wird und für die Topologiestufe verantwortlich ist, entfallen. Mit herkömmlichen Techniken ist dies jedoch nicht möglich, da dann die Titansilizidschicht direkt mit der über der ersten und einzigen Polysiliziumschicht erzeugten Oxidschicht in Berührung kommt und diese verändert. Die Reaktion vom Titansilizid mit dem Oxid kann die Gitterstruktur lokal verändern und die isolierende Wirkung der Oxidschicht herabsetzen. Da jedoch nichtflüchtige Speicherzellen wie z. B. EEPROMs die gespeicherte Ladung bis zu 10 Jahren sicher speichern müssen, sind schon kleinste Veränderungen der Oxidschicht nicht hinnehmbar. Aus diesem Grund wird in den Speichertransistoren zunächst eine zweite Schicht aus Polysilizium auf die Oxidschicht aufgebracht und dann erst die leitfähigkeitssteigernde Titansilizidschicht aufgebracht.

Erfindungsgemäß hingegen wird die zweite Gateschicht aus einem Material hergestellt, das anders als Titansilizid auf die isolierende Schicht aufbringbar ist, ohne diese zu verändern, so daß die zweite Schicht aus Polysilizium entfallen kann. Die zweite Gateschicht aus dem entsprechenden Material wird somit in den Speicherbereichen als weitere Gateschicht unmittelbar auf die isolierende Schicht aufgebracht. Die isolierende Schicht (aus Siliziumdioxid oder einem anderen Dielektrikum) wird wie bei herkömmlichen Verfahren durch leichte Oxidation der unteren und einzigen Polysiliziumschicht in den Zellenbereichen erzeugt und führt selbst noch nicht zu einer Topologiestufe. Die zweite Gateschicht wird ohne Veränderung der isolierenden Schicht direkt auf diese aufgebracht und befindet sich somit in den Speicherbereichen und Logikbereichen auf in etwa gleicher Höhe über der Substratoberfläche. Nachfolgende Schichten können dadurch leichter und mit breiterem Prozeßfenster aufgetragen werden.

Bevorzugte Ausführungsformen sehen vor, daß auf die zweite Gateschicht eine siliziumhaltige Schicht aufgebracht wird, daß mit dieser die zweite Gateschicht silizidiert wird, und daß die siliziumhaltige Schicht aus amorphem Silizium, Titansilizid oder Wolframsilizid besteht. Der Einbau von Silizium in die zweite Gateschicht führt zu besonders temperaturstabilen und niederohmigen Materialzusammmensetzungen.

Vorzugsweise ist vorgesehen, daß auf den ersten Flächenbereichen Logikschaltungen und auf den zweiten Flächenbereichen nichtflüchtige Speicherzellen, insbesondere Floating-Gate-Speicherzellen angeordnet werden. In den Speicherbereichen bildet die erste Gateschicht das Floating-Gate, das oberflächlich oxidiert wird, wohingegen die zweite Gateschicht das Control-Gate bildet.

Die Erfindung sieht vor, daß in die erste Gateschicht und in das Halbleitersubstrat vor dem Aufbringen der zweiten Gateschicht Shallow Trenches geätzt werden. Der Einsatz von Shallow Trenches bietet sich insbesondere dann an, wenn einige Gatestrukturen stark positiv, andere hingegen stark negativ dotiert werden, um die Gatedotierung jedes Transistors der Dotierung der darunterliegenden Wanne anzugleichen. Die in hoher Konzentration in die Gatestrukturen eingebrachten Dotierstoffe beiderlei Leitungstyps können innerhalb der integrierten Halbleiterschaltung diffundieren, insbesondere bei der Fertigung durch Wärmeeinwirkung. Die Shallow Trenches hingegen unterdrücken eine solche Dotierstoffdiffusion und sind zugleich als Implantationsmaske zur selbstjustierten Implantation der Dotierstoffe verwendbar.

Eine Weiterbildung sieht vor, daß Seitenwände der Shallow Trenches leicht oxidiert werden. Hintergrund dieser Ausführungsform ist die Beobachtung, daß in der zwischen dem Gate und dem Halbleitersubstrat befindlichen Oxidschicht häufig eine Dünnung an Seitenwänden von Shallow Trenches auftritt, die bei erhöhten Spannung zu einem Oxiddurchbruch führen kann. Solche erhöhten Spannungen treten beispielsweise beim Beschreiben von Speicherzellen auf. Durch die Oxiddünnung wird ferner die Haltezeit der in Floating-Gate gespeicherten Ladung durch parasitäre Tunnenströme reduziert. Durch leichtes Oxidieren der Shallow Trenches hingegen wird die Oxidschicht verdickt ; es bilden sich sogenannte Vogelschnäbel aus, die einen Oxiddurchbruch wirksam verhindern.

Bevorzugte Ausführungsformen sehen vor, daß die erste Gateschicht im wesentlichen aus Polysilizium und die zweite Gateschicht im wesentlichen aus Titannitrid besteht. Titannitrid hat insbesondere den Vorzug, daß es als Diffusionsbarriere für diffundierte Ionen eine Dotierstoffdiffusion durch die Gate-Metallisierung hindurch verhindert.

Schließlich ist vorgesehen, daß durch das Silizidieren der zweiten Gateschicht Titansilizid gebildet wird, und daß die isolierende Schicht im wesentlichen aus einem Oxid, vorzugsweise Siliziumdioxid besteht.

Die Erfindung wird nachstehend anhand der Figuren 1 bis 6 beschrieben. Es zeigen in schematischer Ansicht:
Figur 1 eine integrierte Schaltung mit einem Logik- und einem Speichertransistor in herkömmlicher Bauweise und die
Figuren 2 bis 6 eine integrierte Schaltung mit Logiktransistoren und einem erfindungsgemäß hergestellten Speichertransistor in verschiedenen Verfahrensschritten.

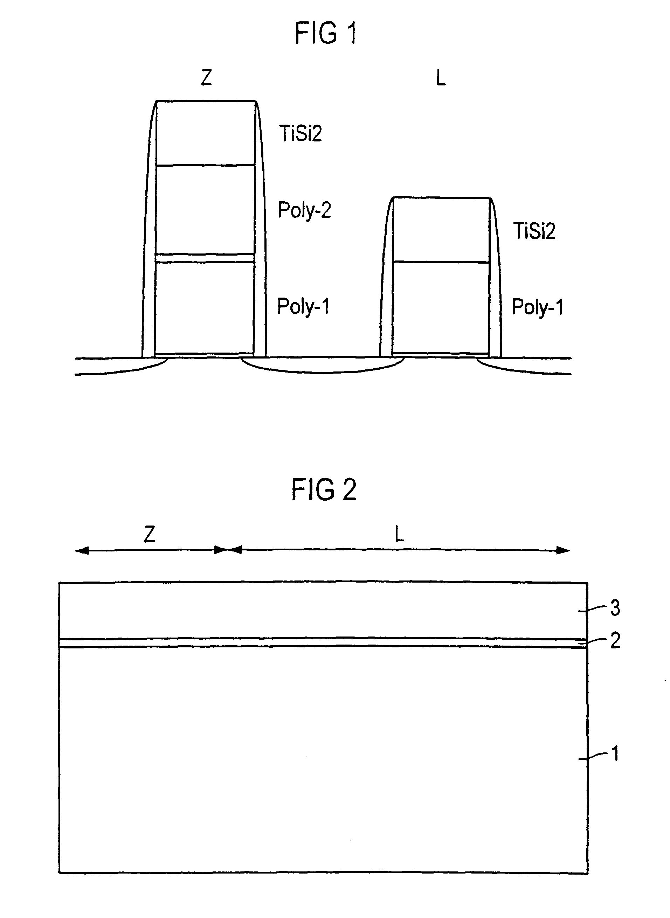

Der in Figur 1 im Logikbereich L befindliche Transistor weist eine Gatestruktur aus einer (ersten) Polysiliziumschicht und einer Titansilizidschicht auf. Beide Schichten wurden ebenso auf dem Speicherzellenbereich Z abgeschieden und bilden das Floating Gate und die leitfähigkeitssteigernde obere Schicht des Control Gate. Die eigentliche das Control Gate bildende Schicht ist eine zweite Polysiliziumschicht, die ausschließlich auf dem Speicherzellenbereich abgeschieden wurde. Durch diese Schicht entsteht zwischen den Bereichen Z und L eine Höhendifferenz, die sich auch nach Abscheidung der Titansilizidschicht fortsetzt.

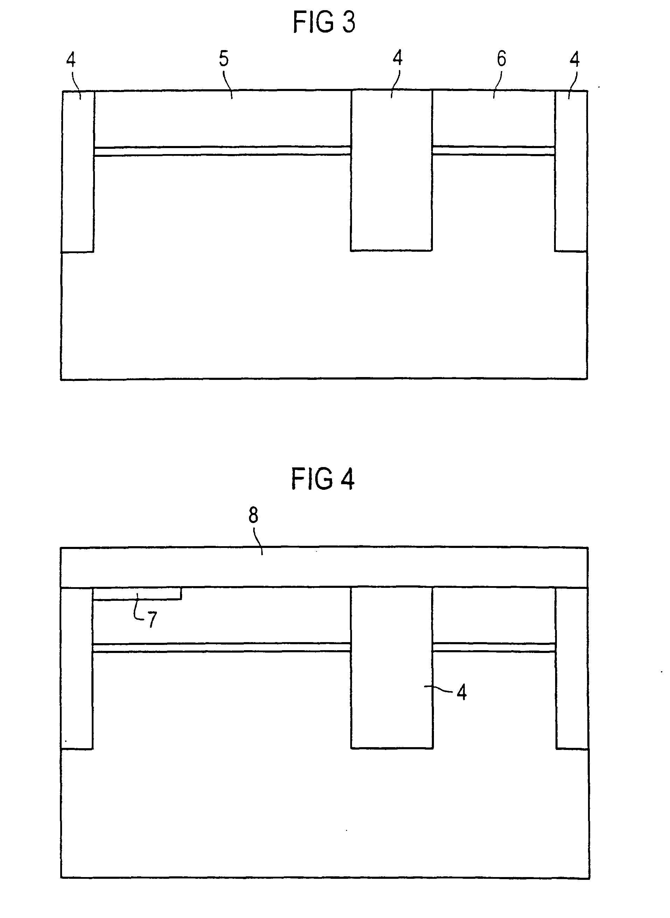

Die Herstellung dieser Struktur beginnt mit der Abscheidung der Polysiliziumschicht 3 auf dem mit einem Oxid 2 bedeckten Halbleitersubstrat 1, wie in Figur 2 dargestellt. In diese Struktur werden dann Shallow Trenches 4 geätzt, die zur Strukturierung von Gatebereichen 5 und 6 dienen, die mit Dotierstoffen hoher Konzentration, aber entgegengesetzten Leitungstyps 5 bzw. 6 dotiert werden. Die in Figur 3 dargestellte Struktur wird dort, wo Floating Gate Transistoren gebildet werden, an der Oberfläche leicht oxidiert, so daß sich die in Figur 4 dargestellte Oxidschicht 7 bildet.

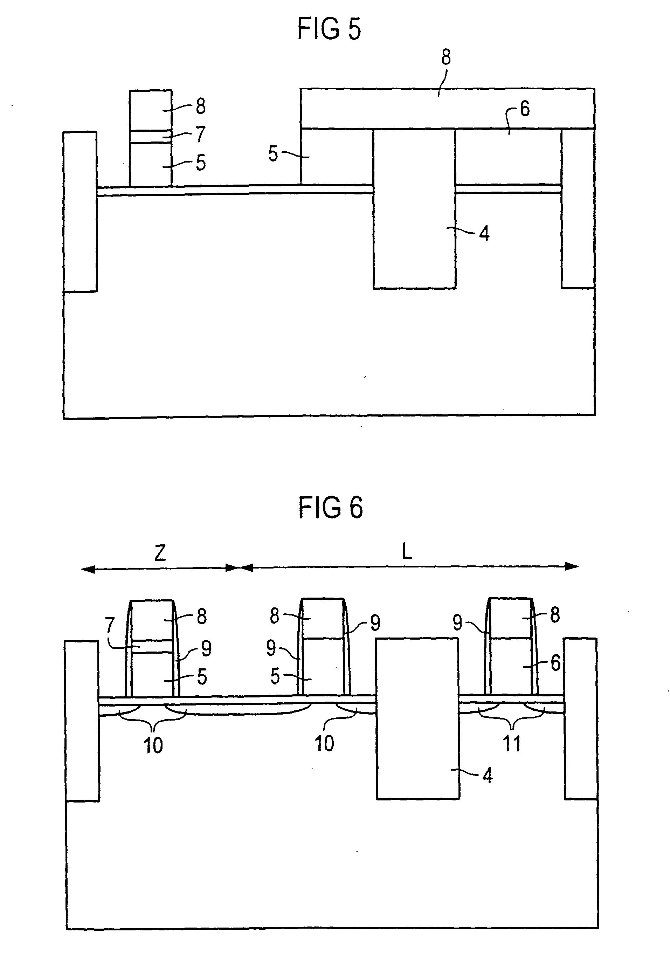

Bei herkömmlichen Verfahren wird auf dieser Oxidschicht zunächst eine zweite Polysiliziumschicht abgeschieden. Erfindungsgemäß jedoch wird eine Schicht 8, die nicht nur auf der ersten Polysiliziumschicht 5, 6, sondern auch auf dem Oxid 7 abscheidbar ist, ohne dieses zu verändern, auf den Logik- wie auch den Speicherzellenbereich aufgebracht. Die Schicht 8 besteht vorzugsweise aus Titannitrid, welches eine laterale Dotierstoffdiffusion über die Shallow Trenches zwischen den Bereichen 5 und 6 verändert, und welches in dem Speicherzellenbereich die gesamte den Transistor steuernde Elektrode bildet, wie in Figur 5 dargestellt. Schließlich werden Spacer 9 aufgebracht und negative bzw. positive Dotierungen 10 bzw. 11 in hoher Konzentration in die Source- und Drain-Gebiete eingebracht, wie in Figur 6 dargestellt.

Auf der oberen Gateschicht 8 können auch weitere Schichten abgeschieden sein, etwa amorphes Silizium, Titansilizid oder Wolframsilizid, die später eine selektive Silizidierung von Gate und Source-/Drain-Gebieten ermöglichen.

Die hier beschriebene Gate-Struktur aus einem Bottom-Gate 5, 6 und einem Top-Gate 8 ist insbesondere dann zweckmäßig, wenn stark p- und n-dotierte Gateschichten vor einer wechselseitigen Dotierstoffdiffusion geschützt werden sollen. Eine Diffusion direkt in lateraler Richtung wird durch die eingebrachten Shallow Trenches 4 verhindert, die zunächst geätzt, dann leicht anoxidiert werden und dann mit einem Oxid gefüllt und planarisiert werden. Auf die planarisierte Struktur wird dann mit Hilfe üblicher Photomasken die Implantation der Wannen und Kanäle sowie der durch die Trenches 4 vorstrukturierten Gateschichten 5 und 6 vorgenommen.

Das erfindungsgemäße Verfahren eignet sich insbesondere zur Fertigung von Embedded EPROMs, wo kleinere Speicherbereiche in einen Logikbereich eingebracht sind. Weitere Ausführungsarten ergeben sich bei Anwendung der Kenntnisse und Fähigkeiten des Fachmanns.

## Patentansprüche

1. Verfahren zur Herstellung einer integrierten Halbleiterschaltung, bei dem
a) eine erste Gateschicht (3; 5, 6) auf erste (L) und zweite Flächenbereiche (Z) eines Halbleitersubstrats (1) aufgebracht wird;
b) auf der ersten Gateschicht (3; 5, 6) in den zweiten Flächenbereichen (Z) eine isolierende Schicht (7) erzeugt wird;
c) auf den ersten und zweiten Flächenbereichen (L, Z) eine zweite Gateschicht (8) aufgebracht wird, wobei
die zweite Gateschicht (8) aus einem Material hergestellt wird, das auf die isolierende Schicht (7) aufbringbar ist, ohne diese zu verändern, und
die zweite Gateschicht (8) in den zweiten Flächenbereichen (Z) als weitere Gateschicht unmittelbar auf die isolierende Schicht (7) aufgebracht wird; und
d) in die erste Gateschicht (3; 5, 6) und in das Halbleitersubstrat (1) vor dem Aufbringen der zweiten Gateschicht (8) Shallow Trenches (4) geätzt werden.

2. Verfahren nach Anspruch 1,
**dadurch gekennzeichnet,**
**daß** auf die zweite Gateschicht (8) eine siliziumhaltige Schicht aufgebracht wird.

3. Verfahren nach Anspruch 2,
**dadurch gekennzeichnet,**
**daß** mit Hilfe der siliziumhaltigen Schicht die zweite Gateschicht (8) silizidiert wird.

4. Verfahren nach einem der Ansprüche 2 oder 3,
**dadurch gekennzeichnet,**
**daß** die siliziumhaltige Schicht aus amorphem Silizium, Titansilizid oder Wolframsilizid besteht.

5. Verfahren nach einem der Ansprüche 1 bis 4,
**dadurch gekennzeichnet,**
**daß** auf den ersten Flächenbereichen (L) Logikschaltungen und auf den zweiten Flächenbereichen (Z) nichtflüchtige Speicherzellen, insbesondere Floating-Gate-Speicherzellen angeordnet werden.

6. Verfahren nach Anspruch 5,
**dadurch gekennzeichnet,**
**daß** die erste Gateschicht (5) in den zweiten Flächenbereichen (Z) Floating Gates bildet.

7. Verfahren nach Anspruch 5,
**dadurch gekennzeichnet,**
**daß** die zweite Gateschicht (8) in den zweiten Flächenbereichen (Z) Control Gates bildet.

8. Verfahren nach einem der Ansprüche 1 bis 7,
**dadurch gekennzeichnet,**
**daß** Seitenwände der Shallow Trenches (4) leicht oxidiert werden.

9. Verfahren nach einem der Ansprüche 1 bis 8,
**dadurch gekennzeichnet,**
**daß** die erste Gateschicht (5) Polysilizium aufweist.

10. Verfahren nach einem der Ansprüche 1 bis 9,
**dadurch gekennzeichnet,**
**daß** die zweite Gateschicht (8) Titannitrid aufweist.

11. Verfahren nach einem der Ansprüche 3 bis 10,
**dadurch gekennzeichnet,**
**daß** durch das Silizidieren der zweiten Gateschicht (8) Titansilizid gebildet wird.

12. Verfahren nach einem der Ansprüche 1 bis 11,
**dadurch gekennzeichnet,**
**daß** die isolierende Schicht (7) Siliziumdioxid aufweist.

13. Verfahren nach einem der Ansprüche 1 bis 12,
**dadurch gekennzeichnet,**
**daß** die zweite Gateschicht (8) eine höhere elektrische Leitfähigkeit als die erste Gateschicht (5) aufweist.

## Claims

1. Method for fabricating an integrated semiconductor circuit, in which
a) a first gate layer (3; 5, 6) is applied to first surface regions (L) and second surface regions (Z) of a semiconductor substrate (1);
b) an insulating layer (7) is produced on the first gate layer (3; 5, 6) in the second surface regions (Z);
c) a second gate layer (8) is applied to the first and second surface regions (L, Z),
the second gate layer (8) being produced from a material which can be applied to the insulating layer (7) without altering the latter, and
the second gate layer (8), in the second surface regions (Z), being applied direct to the insulating layer (7) as a further gate layer; and
d) shallow trenches (4) being etched into the first gate layer (3; 5, 6) and into the semiconductor substrate (1) prior to the application of the second gate layer (8).

2. Method according to Claim 1, **characterized in that** a silicon-containing layer is applied to the second gate layer (8).

3. Method according to Claim 2, **characterized in that** the second gate layer (8) is silicided with the aid of the silicon-containing layer.

4. Method according to either of Claims 2 and 3, **characterized in that** the silicon-containing layer consists of amorphous silicon, titanium silicide or tungsten silicide.

5. Method according to one of Claims 1 to 4, **characterized in that** logic circuits are arranged on the first surface regions (L), and nonvolatile memory cells, in particular floating gate memory cells, are arranged on the second surface regions (Z).

6. Method according to Claim 5, **characterized in that** the first gate layer (5) forms floating gates in the second surface regions (Z).

7. Method according to Claim 5, **characterized in that** the second gate layer (8) forms control gates in the second surface regions (Z).

8. Method according to one of Claims 1 to 7, **characterized in that** sidewalls of the shallow trenches (4) are slightly oxidized.

9. Method according to one of Claims 1 to 8, **characterized in that** the first gate layer (5) includes polysilicon.

10. Method according to one of Claims 1 to 9, **characterized in that** the second gate layer (8) includes titanium nitride.

11. Method according to one of Claims 3 to 10, **characterized in that** titanium silicide is formed by the siliciding of the second gate layer (8).

12. Method according to one of Claims 1 to 11, **characterized in that** the insulating layer (7) includes silicon dioxide.

13. Method according to one of Claims 1 to 12, **characterized in that** the second gate layer (8) has a higher electrical conductivity than the first gate layer (5).

## Revendications

1. Procédé de production d'un circuit à semi-conducteur intégré, dans lequel
a) on dépose une première couche (3 ; 5,6) de grille sur des premières (L) et deuxièmes (Z) parties de surface d'un substrat (1) semi-conducteur ;
b) on produit une couche (7) isolante sur la première couche (3 ; 5,6) de grille dans les deuxièmes parties (Z) de surface ;
c) on dépose une deuxième couche (8) de couche sur les premières et deuxièmes parties (L, Z) de surface, dans lequel
on produit la deuxième couche (8) de grille en un matériau qui peut être déposé sur la couche (7) isolante sans la modifier et
on dépose la deuxième couche (8) de grille dans les deuxièmes parties (Z) de surface en tant que couche de grille supplémentaire directement sur la couche (7) isolante ; et
d) on ménage par attaque des Shallow Trenches (4) dans la première couche (3 ; 5,6) de grille et dans le substrat (1) semi-conducteur avant le dépôt de la deuxième couche (8) de grille.

2. Procédé suivant la revendication 1,
**caractérisé**
**en ce que** l'on dépose une couche contenant du silicium sur la deuxième couche (8) de grille.

3. Procédé suivant la revendication 2,
**caractérisé**
**en ce que** l'on siliciure la deuxième couche (8) de grille à l'aide de la couche contenant du silicium.

4. Procédé suivant la revendication 2 ou 3,
**caractérisé**
**en ce que** la couche contenant du silicium est en silicium amorphe, en siliciure de titane ou en siliciure de tunsgtène.

5. Procédé suivant l'une des revendications 1 à 4,
**caractérisé**
**en ce qu'**il est disposé sur les premières parties (L) de surface des circuits logiques et sur les deuxièmes parties (Z) de surface des cellules de mémoire non volatiles, notamment des cellules de mémoire à grille flottante.

6. Procédé suivant la revendication 5,
**caractérisé**
**en ce que** la première couche (5) de grille forme des grilles flottantes dans les deuxièmes parties (Z) de surface.

7. Procédé suivant la revendication 5,
**caractérisé**
**en ce que** la deuxième couche (8) de grille forme des grilles de commande dans les deuxièmes parties (Z) de surface.

8. Procédé suivant l'une des revendications 1 à 7,
**caractérisé**
**en ce que** des parois latérales des Shallow Trenches (4) sont oxydées légèrement.

9. Procédé suivant l'une des revendications 1 à 8,
**caractérisé**
**en ce que** la première couche (5) de grille comprend du polysilicium.

10. Procédé suivant l'une des revendications 1 à 9,
**caractérisé**
**en ce que** la deuxième couche (8) de grille comprend du nitrure de titane.

11. Procédé suivant l'une des revendications 3 à 10,
**caractérisé**
**en ce que** du siliciure de titane est formé par la siliciuration de la deuxième couche (8) de grille.

12. Procédé suivant l'une des revendications 1 à 11,
**caractérisé**
**en ce que** la couche (7) isolante comprend du dioxyde de silicium.

13. Procédé suivant l'une des revendications 1 à 12,
**caractérisé**
**en ce que** la deuxième ouche (8) de grille a une conductivité électrique plus grande que la première couche (5) de grille.
